Europäisches Patentamt

European Patent Office

Office européen des brevets

(11) Publication number: **0 316 143**
**A2**

# EUROPEAN PATENT APPLICATION

(21) Application number: 88310505.8

(51) Int. Cl.⁴: **C25D 13/02**

(22) Date of filing: **08.11.88**

(30) Priority: **09.11.87 US 118657**

(43) Date of publication of application:
**17.05.89 Bulletin 89/20**

(84) Designated Contracting States:
**AT BE CH DE ES FR GB GR IT LI LU NL SE**

(71) Applicant: **AMETEK INC.**
**410 Park Avenue**
**New York New York 10022(US)**

(72) Inventor: **Schmidt, Ferenc**
**619, Rose Lane**
**Brynmawr Pennsylvania 19010(US)**

(74) Representative: **Dixon, Donald Cossar et al**
**Gee & Co. Chancery House Chancery Lane**
**London WC2A 1QU(GB)**

(54) Formation of superconducting articles by electrodeposition.

(57) A method for depositing superconducting ceramic materials on an article by electrodeposition including the steps of obtaining a dispersion of the components of a superconducting ceramic material in a non-aqueous medium and creating an electrical field within the medium such that the material will migrate to and deposit on an electrode placed within the medium.

EP 0 316 143 A2

## FORMATION OF SUPERCONDUCTING ARTICLES BY ELECTRODEPOSITION

The invention relates to the formation of useful superconducting articles of various shapes and sizes by utilizing electrodeposition techniques.

A new class of metal-oxide ceramics, known generally as superconductors, can conduct electricity with virtually no resistance at temperatures above the boiling point of liquid nitrogen (77K or -196°C). One such superconductor is the yttrium-barium-copper oxide with the approximate composition of $Y_{1.2}Ba_{0.8}CuO_4$. The Y-Ba-Cu-O superconductor (which may contain two distinct phases, one green and one black) has been the subject of intense experimentation regarding appropriate substitutions for yttrium, barium and copper in order to determine the effect of such substitutions on the transition temperature (i.e., the temperature at which the material becomes superconductive). For example, yttrium can be replaced by most other rare earth elements, barium can be replaced by other alkali earth metals and oxygen can be replaced at least partially by fluorine. At present, however, a successful substitute for copper has not been found, although at least the following elements have been unsuccessful substitutes: Ag, Au, Fe, Ni and Co.

Most common processing techniques include solid-state reactions and solution co-precipitation to form bulk Y-Ba-Cu-O based materials. Vapor deposition, sputtering, plasma spray, and molecular beam epitaxy are among those for producing thin films. Sol gel method has also attracted attention for synthesizing extremely homogenous and fine particles. Superconductors exhibiting very high critical current densities as required in large scale applications are currently being sought.

Difficulties in this area are partly due to the intrinsically large anisotropy and complex grain boundaries of the orthorhombic ceramic materials. As a result, efforts are being placed on developing techniques suitable for enhancement of grain alighment as well as for conditioning their boundaries.

A typical recipe for creating the Y-Ba-Cu-O superconducting material calls for heating an intimate mixture of the oxide or carbonate powders of the elements at temperatures between 900 and 1100°C. This drives off carbon dioxide from the carbonates and converts them to oxides. After regrinding and reheating, the mixture is pressed into pellets and sintered (bonded without melting) at the same temperatures noted above for several hours. The pellets are then re-oxygenated at a lower temperature, typically 400 to 550°C.

Generally, pellet or coupon shapes are easy to fabricate from the superconducting material but are not particularly useful. Tubular or wire shapes would be the most desirable; however, the brittle and fragile coupons cannot be drawn out to form wires as copper and other ductile metals can. In one process for fabricating a useful wire shape, the ceramic superconducting powder was mixed with an organic binder and used to fill metal tubing, which was then drawn through a die to reduce its diameter. In other attempts the binder-superconductor powder mixture was bonded to a substrate, such as a non-superconducting wire made out of copper.

In order to find an effective method for forming useful articles out of superconducting ceramic material, the following fabrication processes have also been used or proposed: evaporation, sputtering, rapid solidification on substrates, calcining-grinding-sintering to final shape or to an intermediate shape followed by machining, high pressure oxygen sintering, isostatic pressing, coprecipitation-sintering, extrusion, explosive compacting. Unfortunately, the techniques described above are extremely limited in effectiveness and as to the type of superconducting article which can be produced. As a result, one of the major problems facing the superconductor industry is the development of suitable fabrication techniques which will enable the formation of the superconducting ceramic material into useable shapes and articles.

Accordingly, it is an object of the present invention to provide a fabrication technique which enables the formation of superconducting ceramic material into useable shapes and articles.

Another object of the present invention is the use of electrodeposition techniques to fabricate superconducting ceramic material into useable shapes and articles.

Still another object of the present invention is the use of electrophoresis and dielectrophoresis to fabricate superconducting ceramic material into useable shapes and articles.

A further object of the present invention is the use of electrodeposition techniques to fabricate superconducting ceramic material into complex shaped articles.

A still further object of the present invention is the use of electrodeposition techniques to coat articles with superconducting ceramic material.

An additional object of the present invention is the use of electrodeposition techniques to achieve a coating of superconducting ceramic material of uniform thickness on an article.

The invention is the use of electrodeposition techniques (especially electrophoresis and dielectrophoresis) for fabricating useful articles out of superconducting ceramic material. As used herein, the term "superconducting ceramic materials" includes the Y-Ba-Cu-O superconductor as well as superconductors utilizing additional components or substitute components (including substitutes for copper) as well as superconductors of other formulations which may be developed in the future. One or more elements in the Y-Ba-Cu-O base compound may be substituted with other elements, typically, rare earth elements for Y, Sr or Ca for Ba, other metallic elements for Cu, and F for O. The purpose of this substitution may be to improve the mechanical behavior and thermal and environmental stability of the resulting superconductors.

Electrophoresis involves the suspension in a liquid of certain finely divided materials which are then found to possess an electrical charge. The polarity of this charge depends upon the nature of the material and the dispersion medium. For example, carbon, metals, sulphur and cellulose in high purity water are found to have a negative charge, due to the absorption of hydroxyl ions; however, metal oxides and hydroxides possess a positive charge, due to the absorption of hydrogen ions. The fact that these suspensoid particles have a charge means that they will move under the influence of a d-c electrical field.

This basic motion has made it possible to deposit various types of coatings. The list of substances which can be deposited this way includes rubber, latex, oxides, metals, lubricants, cellulose, graphite and natural or synthetic resins, and now superconducting ceramic materials.

It is necessary to use a non-aqueous liquid medium in electrophoretic techniques for superconducting ceramic materials since the rare earth (yttrium) and alkali earth (barium) metal oxides react with water (which reaction would ruin the superconducting ceramic material). As in all industrial electrophoretic processes, the medium should be non-conducting.

The superconducting ceramic material is not dissolved in the medium, but merely suspended. Acceptable media include, for example, acetone, tolulene and methyl-ethyl ketone. Two electrodes are placed in the bath. The electrodes represent an anode and a cathode and may be formed of the conventional electrode materials, such as steel, copper, carbon, aluminum, etc.

A potential of several hundred volts is applied across the electrodes and this produces a migration of the material to either the anode or the cathode depending upon the electric charge the material carries. The material is discharged and deposited on the appropriate electrode, which may constitute the desired shape (e.g., a copper wire). A great advantage of this technique is the fact that even if the electrode is an irregular shape, a uniform coating of the material will result because of the additional resistance due to the build up of coating. As such, this technique is ideal for creating complex shaped superconducting articles.

Once a quantity of the powder is deposited (which could take minutes to hours), the coated electrode can be removed from the bath and may be processed further, if required. After the final desired shape is achieved, it can then be heated (sintered) to bond the deposited particles to one another and thus yield a stronger article. The sintering can be done at 300° C to 1000° C. However, after sintering at a temperature higher than 300° C it is necessary to re-oxygenate the superconductor to compensate for any oxygen loss occuring at high temperature.

A variation of this process included in this invention is dielectrophoresis. In this technique (which is similar to electrophoresis) the intensity of the electric field is non-uniform and the particles migrate towards the area of increasing field intensity independent of preexisting charge. In an example of a dielectrophoretic bath a central wire and a concentric cylinder are the two electrodes and the particles migrate onto the wire (e.g. the center of the bath). This technique is extremely well suited for wire cladding with superconducting material.

One embodiment of the invention includes the initial step of preparing a colloidal dispersion of yttrium, barium and copper carbonates, or substitutions of any or all of these elements, in a non-conducting, polar organic medium. As used herein, the term "colloids" means particles of a size less than a micron in diameter, which particles do not settle out of the medium easily. It may be advantageous to vary the particle size of the yttrium, barium and copper carbonates to achieve a denser deposition.

As noted above, the dispersion medium may be acetone, toluene, methyl-ethyl ketone, isobutyl alcohol, propylene carbonate, amyl acetate, butyl acetate, etc., or mixtures thereof, and other media which are commonly used in electrophoresis. Organic media are sensitive to moisture and may require use of a controlled atmosphere conditions. Preparation of the superconducting ceramic material for dispersion in the medium usually consists of grinding in a colloid mill or mortar followed by ultrasonic vibration or any other method which will result in a suspension of the superconducting ceramic material in the medium. A small amount of surfactant is added to increase the electric charge on the particles.

An alternate process for the preparation of the suspension is the preparation of an aqueous solution of yttrium, barium and copper nitrates, followed by addition of oxalic acid and ammonia in order to coprecipitate Y, Ba and Cu oxalates. This would achieve finer intermixing than colloid milling. Of course, the anion does not need to be oxalate, carbonates and hydroxides could also be used; however, the dissociation constants of the respective oxalates are extremely small, $K_p = 8 \times 10^{-23}$, $1.6 \times 10^{-7}$ and $2.3 \times 10^{-8}$, respectively. The precipitates are filtered on a Gooch filter, washed, dried and can be ultrasonically dispersed as above.

Electrophoretic deposition of the material is then accomplished using a typical voltage in the order of 5-100 volts per cm of electrode separation. The amount of time required is a function of the concentration of charged particles and electric field intensity, and ranges from several minutes to hours per mil thickness of deposit, which can be a fast deposition process. However, high field intensities permit better axial alignment of the particles. Therefore, low concentrations of charged particles are used to permit application of higher voltages. The electrodes can be formed of just about any conductive material, e.g. metal or alloy, and in just about any configuration, e.g. strips, wires, etc.

After the deposition step the material is sintered by, for example, radio frequency induction heating. This is a fast process with rapid heating. Because of the rapid heating, diffusion of the substrate and the consequent contamination of the superconductor by the diffused atoms is sharply reduced or eliminated. Use of radio frequency induction heating takes the place of the otherwise lengthy heat soaking process which typically requires 10 to 16 hrs at 900-930° C.

Finally, oxygen annealing at lower termperatures re-establishes the correct oxygen ratio. This step is the same as in any other powder metallurgical superconductor fabrication process.

## Example 1

Separately, one gram each of yttrium, barium and copper carbonates wetted with methy-ethyl ketone were ground by hand (instead of a colloid mill) for thirty minutes in glass mortars. The resulting pastes were ultrasonically dispersed into 200 ml MEK in a glass beaker. One cm wide aluminum strip electrodes were placed in the glass beaker 2.5″ apart.

The voltage was slowly raised to 500 V without any sign of deposition. The experiment was repeated; however, this time .2 ml of ZONYL FCA, a trade name of Dupont for fluorosurfactants, was added. The recommended range for the surfactant is .005 to .1% per volume of medium. Other surfactants may also be used, such as TRITON (Rohm & Haas Co.) and TERGITOL (Union Carbide). Preferably, the surfactant is added during grinding, however, in this example it was added to the existing bath. With the use of a surfactant, deposition on the anode started immediately once the voltage reached the range of 15-30 V (the lower range of deposition voltage is for Y, the higher deposition voltage for Ba). The deposit was very uniform, well adherent and ready for sintering. The deposit had the typical "green strength" characteristics familiar in powder metallurgy.

The amount deposited was a linear function of the voltage and ranged from 1.4 mg/cm$^2$ at 50 V for the Ba carbonate to 4.3 mg/cm$^2$ for the Y carbonate, copper being in between.

The following is the basic linear equation for electrophoresis:

$$W = XpetS(C/6)(3.14)v$$

where W = weight of deposit
X is the potential gradient
p is electrokinetic potential
e is the dielectric constant of the medium
t is time
S is electrode surface area
C the concentration of particles
v is the viscosity of the medium.

This equation teaches how to obtain the deposition velocities necessary for achieving a certain composition. A simple approach is to have lower concentration of the faster depositing carbonate and vice versa. Fine tuning can be achieved by changing the other parameters, such as particle size (for p), use of other media (for changing e, etc.).

The three pastes were mixed and a uniform, homogenous 3 mil thick YBa-Cu carbonate deposit was obtained at 30 volts in 5 minutes. Subsequently, it was found that higher voltages (several hundered and up) permitted better crystallographic alignment of the deposit.

In further experiments conducted in accordance with this invention a YBa$_2$Cu$_3$O$_{7-x}$ powder was electrophoretically deposited onto both copper and silver coils.

Electrophoretic deposition is a lower cost, simpler and faster superconductor fabrication technique than any other currently known technique. It appears to have the following very important advantages: eliminates the need for the isostatic pressing necessary in powder metallurgy (because the deposit is dense and compact), eliminates the very long high temperature heating needed to provide interdiffusion (because the particles are so intimately mixed and the crystallites are very uniform) and, for the same reason, this approach eliminates contamination resulting from substrate diffusion into the superconductor. In addition, the film thickness can be varied by voltage adjustment and uniform results are obtained on complex shapes.

Further, electrophoretic deposition, can achieve enhancement of grains alignment and grain boundary conditioning. Several controllable variables are present in this process: concentrations of individual ingredients, dielectric constant and viscosity of the medium, applied voltages, and types of surfactants. The last two factors contribute to the preferential orientation during deposition, while all the four factors can be selected to provide other aspects of the products microstructures. Electron microscope examination of superconductors formed by electrophetic deposition in accordance with this invention reveal some alighment of the individual particles. Present superconductros only conduct 500 amp/cin since only 1% of their particles are aligned (i.e., continuous filaments are approximately on percent of volume). Each additional percentage of increase is alignment is therefore highly significant.

As noted above, this invention allows the production of superconductors of various geometries. This can be achieved by pre-forming the electrode, over which the depossition occurs, into the specific shape required for a given application. This advantage is significant, considering the brittleness of the oxide ceramics, which makes most of the conventional metal-forming techniques unpractical.

The starting materials of electrophoretic deposition can be either finely-ground Y-Ba-Cu-O compound particles or individual ingredients such as Y-, Ba-, and Cu-oxide. The latter case, with the ingredient particles homogeneously mixed at the molecular level, combines syntheses with processing and has advantages similar to those of the sol gel approach. The resulting fine-particle products can then be sintered at relatively low temperatures due to the short diffusion distances.

For large scale applications of superconductors such as generators, motors, and electromagnets, the superconductor materials must be in wire form, which can then be processed into windings. As noted above, the dielectrophoretic deposition process of this invention is ideal for forming wires. In contrast to the electrophoretic process which works on the principle of having dispersed particles moving across a relatively uniform potential difference between two electrode plates, the dielectrophoretic process is based on the presence of large potential gradients around the electrodes. Highly polarizable molecules or particles can be aligned to form into shapes dictated by the electrode design. Large potential gradients can be induced around a small radius wire electrode. Therefore, one can conveniently produce a superconducting wire by using a fine wire electrode with the superconducting materials formed over it through the dielectrophoretic process.

This technique is even more attractive for coil formation, particularly if only one layer is required for the coil. In this situation, the electrode is simply a coil of the required geometry.

Alternatively, an insulating tube of the same radius as required for the coil may be coated with a conducting layer, and then etched into a spiral conducting path with the required pitch. Dielectrophoretic process can then proceed with the spiral conducting path as the electrode. If necessary, the electrode itself can always be removed afterwards by heating, if the electrode is of a low melting point material, or if the electrode is of a collapsible design.

Although the invention herein has been described with reference to particular embodiments, it is to be understood that these embodiments are merely illustrative aspects of the invention. Thus, it is to be understand that numerous modifications may be made in the illustrative embodiments and other arrangements may be devised without departing from the spirit and scope of the invention.

## Claims

1. A method for depositing superconducting ceramic material on an article, comprising the steps of:
   (a) obtaining a colloidal dispersion of the components of a superconducting ceramic material in a non-aqueous medium;
   (b) placing two electrodes in the medium of step (a); and
   (c) placing a potential voltage across the two electrodes of step (b) such that the material in the medium deposits on one of the electrodes.

2. The method of Claim 1 which comprises the further step of:
   (d) sintering the coated electrode.

3. The method of Claim 1 which comprises the further steps of:
   (d) removing the coated electrode from the bath and shaping it; and
   (e) sintering the coated electrode.

4. The method of any of Claims 1 to 3 in which the medium is non-conducting.

5. The method of any of Claims 1 to 4 in which the medium is selected from the group consisting of acetone, toluene, methyl-ethyl ketone, isobutyl, alcohol, propylene carbonate, amyl acetate and butyl acetate.

6. The method of any of Claims 1 to 5 which further comprises adding a surfactant to the superconducting ceramic material of step (a).

7. The method of any of Claims 1 to 6 which further comprises adding a surfactant to the medium of step (a).

8. A method for depositing superconducting ceramic materials on an article, comprising the steps of:

(a) obtaining a dispersion of the components of a superconducting ceramic material in a non-aqueous medium;

(b) placing electrodes in the medium; and

(c) creating an electrical field within the medium such that the material will deposit on one of the electrodes.

9. The method of Claim 8 which comprises the further step of:

(d) sintering the coated electrode.

10. The method of Claim 8 which comprises the further step of:

(d) removing the coated electrode from the bath and shaping it; and

(e) sintering the coated electrode.

11. The method of any of Claims 8 to 10 in which the medium is non-conducting.

12. The method of any of Claims 8 to 11 in which the medium is selected from the group consisting of acetone, toluene, methyl-ethyl Ketone, isobutyl, alcohol, propylene carbonate, amyl acetate and butyl acetate.

13. The method of any of Claims 8 to 12 which further comprises adding a surfactant to the superconducting ceramic material of step (a).

14. The method of any of Claims 8 to 13 which further comprises adding a surfactant to the medium of step (a).

15. A method for depositing superconducting ceramic materials on an article comprising the steps of:

(a) preparing a colloidal dispersion of yttrium, barium and copper carbonates in a non-aqueous, non-conducting medium;

(b) placing two electrodes in the medium of step (a); and

(c) applying a potential across the two electrodes of step (b) such that the yttrium, barium and copper carbonates deposit on one of the electrodes.

16. The method of Claim 15 in which the medium is selected from the group consisting of acetone, toluene methyl-ethyl ketone, isobutyl, alcohol, propylene carbonate, amyl acetate and butyl acetate.

17. The method of Claim 15 or 16 which further comprises adding a surfactant to the medium of step (a).

18. The method of any of Claims 15 to 17 which comprises the further step of:

(d) sintering the coated electrode.

19. The method of any of Claims 15 to 17 which comprises the further steps of:

(d) removing the coated electrode from the bath and shaping it; and

(e) sintering the coated electrode.